# NEUE EUROPÄISCHE PATENTSCHRIFT

(11) **EP 0 715 358 B2**
(45) Veröffentlichungstag und Bekanntmachung des Hinweises auf die Entscheidung über den Einspruch: **03.07.2013**
(45) Hinweis auf die Patenterteilung: 23.06.2010
(21) Anmeldenummer: 95118804.4
(22) Anmeldetag: 29.11.1995
(51) Int. Cl.: H01L 31/032, H01L 31/18

(54) **Verfahren zur Herstellung einer Solarzelle mit Chalkopyrit-Absorberschicht und so hergestellte Solarzelle**
Process for fabricating a solar cell with a chalcopyrite absorbing layer and solar cell so produced
Méthode de fabrication d'une cellule solaire avec une couche d'absorption en chalcopyrite et cellule solaire ainsi produite

(30) Priorität: 01.12.1994 DE 4442824
(43) Veröffentlichungstag der Anmeldung: 05.06.1996
(73) Patentinhaber: Saint-Gobain Glass France S.A., 92400 Courbevoie (FR)
(72) Erfinder: Probst, Volker, Dr., D-81547 München (DE); Rimmasch, Jörk, Dr., D-81541 München (DE); Harms, Hauke, D-81737 München (DE)
(74) Vertreter: Lendvai, Tomas

(56) Entgegenhaltungen:
- DE-C- 4 333 407
- 12TH EUROPEAN PHOTOVOLTAIC SOLAR ENERGY CONFERENCE, Bd. 2, 11. - 15.April 1994, AMSTERDAM, NL, Seiten 1592-1595, XP002039461 J. HOLZ ET AL.: "The effect of substrate impurities on the electronic conductivity in CIS thin films"
- 12TH EUROPEAN PHOTOVOLTAIC SOLAR ENERGY CONFERENCE, Bd. 2, 11. - 15.April 1994, AMSTERDAM, NL, Seiten 1743-1746, XP002039462 M. BODEGARD ET AL.: "The influence of sodium on the grain structure of CuInSe2 films for photovoltaic applications"
- PROCEEDINGS OF THE IEEE PHOTOVOLTAIC SPECIALISTS CONFERENCE, LOUISVILLE, MAY 10 - 14, 1993, Nr. CONF. 23, 10. - 14.Mai 1993, INSTITUTE OF ELECTRICAL AND ELECTRONICS ENGINEERS, Seiten 364-371, XP000437970 HEDSTROM J ET AL: "ZNO/CDS/CU(IN,GA)SE2 THIN FILM SOLAR CELLS WITH IMPROVED PERFORMANCE"
- 13TH EUROPEAN PHOTOVOLTAIC SOLAR ENERGY CONFERENCE, Bd. 2, 23. - 27.Oktober 1995, NICE, FR, Seiten 2123-2126, XP002039463 V. PROBST ET AL.: "Improved CIS thin film solar cells through novel impurity control techniques"

## Beschreibung

Ein Hauptziel in der Photovoltaik ist die Entwicklung von möglichst langzeitstabilen und hocheffizienten Solarzellen bei gleichzeitig niedrigen Herstellungskosten. Nur dann wird diese Form der Energieerzeugung gegenüber anderen konventionellen Verfahren konkurrenzfähig.

Bezüglich Wirkungsgrad und Langzeitstabilität gelten derzeit Solarmodule aus einkristallinem Silizium als Standard.

Erfolgversprechende Ansätze zur Herstellung kostengünstiger und langzeitstabiler Solarzellen werden derzeit bei Solarzellen aus polykristallinen I-III-VI₂-Chalkopyrit-Halbleitern vermutet. Insbesondere das CuInSe₂ (CIS) und verwandte Legierungen aus dem System CuIn(Ga)Se₂(S₂) (= CIGS) sind Materialien, die einen hohen Absorptionskoeffizienten, einen direkten Bandübergang und einen dem Sonnenspektrum angepaßten Bandabstand aufweisen. Sie lassen sich in kostengünstigen Dünnschichtabscheideverfahren herstellen und haben in Laborversuchen bereits Wirkungsgrade von über 17 % erreicht.

Eine gängige Zellenstruktur besteht aus einem Glassubstrat, einer Molybdän-Rückelektrode, einer 1 bis 5 µm dicken Absorberschicht aus polykristallinem Chalkopyrit-Halbleiter, einer dünnen Cadmiumsulfidfensterschicht und einer transparenten Frontelektrode.

Es hat sich herausgestellt, daß Rekordwirkungsgrade ausschließlich mit Solarzellen erreicht werden können, die auf alkalihaltigen Glassubstraten, beispielsweise Kalknatronglas hergestellt werden. Mit anderen Materialien wird ein negativer Substrateinfluß auf das Kornwachstum der Chalkopyrit-Absorberschicht festgestellt. Bei ansonsten identischen Herstellungsbedingungen werden mit anderen Substratmaterialien feinkristalline Schichten mit mittleren Korndurchmessern von ca. 200 nm erhalten. Zusätzlich bilden sich an der Oberfläche der Chalkopyrit-Schicht besonders feinkristalline und maximal ca. 50 nm große Kristallite von unterschiedlicher Flächendeckung aus. Diese bewirken eine Reduzierung des Zellenstroms, der maximal erreichbaren Leerlaufspannung, der Kurzschlußstromdichten und des Füllfaktors.

Als Ursache für die Abhängigkeit der Solarzelleneigenschaften werden vom Substrat stammende Verunreinigungen vermutet. Da das Substrat bei der Schichtbildung der Absorberschicht bis nahe an den Erweichungspunkt erhitzt wird, können insbesondere Alkali- und Erdalkaliionen aus dem Substrat in den Halbleiter eindiffundieren. Gängige Substrate aus Floatglas weisen (Erd-)Alkalikonzentrationen von 13 bis 15 Prozent Natrium, 5 bis 7 Prozent Calcium, 4 bis 5 Prozent Magnesium und 0,5 bis 1 Prozent Kalium auf.

Bei der Herstellung von Solarzellen mit Chalkopyrit-Absorberschicht tritt das Problem auf, daß der positive Einfluß von

Kalknatronglas auf die Zelleneigenschaften zusätzlich von der Vorbehandlung des Substratmaterials abhängig ist, beispielsweise von der Reinigung der Oberfläche, von den Lagerungsbedingungen bezüglich Feuchtigkeit, Dauer und Temperatur sowohl der unbeschichteten als auch der mit Molybdänrückelektrode beschichteten Substrate. Auch die Abscheidebedingungen der Molybdänrückelektrode haben einen Einfluß auf die Solarzelleneigenschaften. Es wird vermutet, daß unterschiedliche Abscheidebedingungen primär das Diffusionsverhalten gegenüber Alkali- und Erdalkaliionen beeinflussen. Dafür spricht auch, daß die für die Herstellung der Chalkopyrit-Absorberschicht verwendete Wärmemenge eine weitere Einflußgröße für die Solarzelleneigenschaften ist.

Als weiterer Nachteil ist zu nennen, daß die Chalkopyritschichten oft eine schlechte Haftung auf der Molybdänrückelektrode besitzen.

Eine 100 %ige Prozeßkontrolle, die für die großtechnische Herstellung von hochwertigen Solarzellen mit Chalkopyrit-Absorberschicht erforderlich ist, ist praktisch nur mit sehr großem Aufwand möglich.

Aufgabe der vorliegenden Erfindung ist es daher, ein Verfahren zur Herstellung einer Solarzelle mit Chalkopyrit-Absorberschicht aus dem System CuIn(Ga)Se₂(S₂) (= CIGS) anzugeben, welches den bislang unkontrollierbaren Substrateinfluß auf die Eigenschaften der späteren Solarzelle beseitigt und trotzdem zu einer Solarzelle mit morphologisch gut ausgebildeter Absorberschicht und guten Zelleneigenschaften führt, die Höchstwirkungsgrade erlauben.

Diese Aufgabe wird erfingdungsgemäß durch ein Verfahren nach Anspruch 1 gelöst. Diese Aufgabe wird weiterhin durch eine Solarzelle nach Anspruch 8 gelöst. Weitere Ausgestaltungen der Erfindung sind weiteren Ansprüchen zu entnehmen.

Die Erfindung geht auf die Entdeckung zurück, daß bereits bei Vorhandensein eines Alkalielements in einer Chalkopyrit-Absorberschicht der Wirkungsgrad und andere Eigenschaften daraus hergestellter Solarzellen verbessert werden. Die Einstellung eines gewünschten Alkaligehalts wird bei der Erfindung aber nicht etwa durch eine Unterstützung der Alkalidiffusion aus einem alkalihaltigen Substrat erreicht, sondern im Gegenteil durch vollständige Unterdrückung von Alkalidiffusion in die Absorberschicht und durch dosierte Zugabe eines Alkalielements oder einer Alkalielementverbindung während oder nach der Erzeugung der Rückelektrodenschicht.

Die Erfindung nutzt weiterhin die Erkenntnis, daß die positiven Wirkungen erst bei einem bestimmten Schwellenwert bezüglich einer Alkalikonzentration in der Absorberschicht auftreten. Dieser Schwellenwert läßt sich mit dem erfindungsgemäßen Verfahren sicher erreichen und überschreiten.

Mit der Erfindung wird weiterhin das Problem vermieden, daß bei erhöhter Alkalikonzentration in der Absorberschicht eine verschlechterte Haftung zwischen der Absorberschicht und der sonst üblicherweise verwendeten Molybdänrückelektrode vermieden wird.

Gegenüber einer ansonsten baugleichen Solarzelle, die keinen Alkaligehalt in der Chalkopyrit-Absorberschicht aufweist, werden folgende Verbesserungen der Solarzelleneigenschaften erreicht:
- Die maximal erreichbare Leerlaufspannung der Solarzelle wird um mindestens 80 mV auf 500 mV erhöht;
- die Kurzschlußstromdichten erreichen mehr als 40 mA/cm² und damit beinahe den theoretisch möglichen Maximalwert;
- die Füllfaktoren steigen von bisher maximal 65 Prozent auf über 70 Prozent an;
- die Leerlaufspannung der Solarzelle erhöht sich bereits bei geringsten Alkaligehalten;
- die Haftung der Absorberschicht auf einer Molybdanrückelektrode wird verbessert.

Eine erfindungsgemäß unabhängig vom Substrat hergestellte Absorberschicht besitzt eine für Solarzellen vorteilhafte Morphologie. Sie ist grobkörnig und besitzt mittlere Korndurchmesser im Bereich der Schichtdicke der Absorberschicht, die zwischen 1 und 5 um liegen. Es bildet sich auch keine feinkristalline oberflächenschicht, wie sie bislang bei Absorberschichten auf alkalifreien Substraten beobachtet wurde. Für das erfindungsgemäße Verfahren steht daher eine größere Auswahl geeigneter Substrate zur Verfügung.

Da die genaue Höhe des Alkaligehalts der Absorberschicht entscheidend für die Wirkungsgraderhöhung der Solarzelle verantwortlich ist, wird mit dem erfindungsgemäßen Verfahren erstmals eine einfache Verfahrenskontrolle bezüglich des Alkaligehalts zur Verfügung gestellt. Das Verfahren führt sicher zu Solarzellen mit geeignetem Alkaligehalt in der Absorberschicht, der erst das Erreichen hoher und höchster Wirkungsgrade der Solarzelle ermöglicht.

Erfindungsgemäß wird der gewünschte Alkaligehalt der Absorberschicht vorzugsweise im Bereich der Grenzfläche zur Rückelektrode eingestellt. Experimente haben gezeigt, daß das Einbringen von Alkalielementen von der Oberfläche der Absorberschicht her eine geringere Wirkungsgraderhöhung der Solarzellen zur Folge hat. Doch auch eine Solarzelle mit über die Dicke der Absorberschicht konstantem Alkaligehalt ist gegenüber einer solchen mit alkalifreier Absorberschicht verbessert.

Experimente zum Einbringen von Alkalielementen von der Oberfläche der Absorberschicht werden beschrieben in: 12th European Photovoltaic Solar Energy Conference, Bd. 2, 11. - 15. April 1994, Amsterdam, NL, Seiten 1592-1595, J. HOLZ ET AL.: "The effect of substrate impurities on the electronic conductivity in CIS thin films" und 12th European Photovoltaic Solar Energy Conference, bd. 2, 11. - 15. April 1994, Amsterdam, NL, Seiten 1743 - 1746, M. Bodegard et Al.: "The influence of sodium on the grain strudure of CuInSe2 films for photovoltaic applications".

Der gewünschte Alkaligehalt wird durch dosierte Zugabe einer geeigneten Alkaliverbindung erzeugt. Insbesondere sind dies die jeweiligen Verbindungen mit Sauerstoff, Schwefel, Selen oder den Halogeniden. Da Schwefel und Selen bereits Bestandteil des Chalkopyrit-Halbleiters sind, führen deren Verbindungen mit den Alkalielementen nicht zu zusätzlichen Verunreinigungen in der Absorberschicht.

Die Abscheidung der Alkaliverbindungen erfolgt vorzugsweise durch Sputtern oder Verdampfen. Dabei kann ein Alkaliverbindungstarget oder ein Mischtarget aus der Alkaliverbindung und einem Kupferselenid CuₓSe_{y} oder ein Mischtarget aus der Alkaliverbindung mit einem Indiumselenid InₓSe_{y} verwendet werden. Ebenso ist ein Metall-Alkali-Mischtarget wie Cu/Na, Cu-Ga/Na oder In/Na möglich.

Ein geeigneter Alkaligehalt ist abhängig von der Schichtdicke und vom Herstellverfahren der Chalkopyrit-Absorberschicht, welches die erreichbaren Korngrößen bestimmt. Für ein zweistufiges Herstellverfahren über einen Schichtaufbau mit Ausgangskomponenten und anschließender Überführung in den Verbindungshalbleiter durch schnelles Tempern (Rapid Thermal Annealing) hat sich eine auf die Fläche-der Solarzelle bezogene Dosis von 10¹⁴ bis 10¹⁶ Atomen Alkali pro cm² als vorteilhaft erwiesen. Bei darüberliegenden Konzentrationen kann wieder eine verschlechterte Haftung auftreten.

Die Kontrolle der abgeschiedenen Alkalimenge kann durch eine geeichte Schwingquarzmessung, durch Absorptionsspektroskopie oder durch Massenspektrometrie erfolgen.

Bei Verwendung eines alkalihaltigen Substrats, insbesondere eines Glassubstrats wird eine zusätzliche Alkalidiffusion aus dem Substrat in die Absorberschicht während deren Herstellung durch eine Diffusionssperrschicht verhindert. Dafür sind dünne Schichten aus Siliziumnitrid, Titannitrid, Aluminiumoxid, SiO₂, TiO₂ oder ZrO₂ geeignet. Eine elektrisch isolierende Diffusionssperrschicht aus Aluminiumoxid, Siliziumdioxid, Titanoxid oder Zirkonoxid kann direkt über dem Substrat angeordnet sein.

Die Diffusionssperrschicht darf vor dem Erzeugen der Absorberschicht nicht durch Strukturierungsverfahren verletzt werden. Da dünne Aluminiumoxid- und Siliziumdioxid-Schichten im sichtbaren Bereich transparent sind, kann bei der Verwendung von optisch transparenten Substraten eine Laserstrukturierung von der Rückseite durch das Substrat hindurch erfolgen. Ein solches Verfahren ist beispielsweise in der EP-A 0 536 431 beschrieben. Ein weiteres Strukturierungsverfahren, mit dem die Diffusionssperrschicht nicht verletzt wird, ist die Lift off-Technik. Auch die Anwendung einer Maskentechnik bei der Abscheidung der Rückelektrode führt zu keiner Verletzung der Diffusionssperrschicht.

Eine Diffusionssperrschicht aus leitendem Material kann zwischen Substrat und Rückelektrode oder zwischen Rückelektrode und Absorberschicht angeordnet werden. Zum Erreichen einer Serienverschaltung muß diese dann jedoch zusammen mit der Rückelektrode strukturiert werden. Um eine Diffusion von Alkali während der Bildung der Absorberschicht zu verhindern, darf die gemeinsame Strukturierung von Rückelektrode und Diffusionssperrschicht erst nach der Erzeugung der Absorberschicht erfolgen.

Eine ausreichende Barrierewirkung wird von dünnen Siliziumnitrid-, Titannitrid, Aluminiumoxid-, Titanoxid-, oder Zirkonoxidschichten von ca. 20 bis 100 nm Dicke bewirkt.

Die Diffusionssperrschichten können mit bekannten Abscheideverfahren wie Sputtern von Verbindungstargets oder durch reaktives Sputtern von Elementtargets großflächig, stöchiometrisch und dicht aufgebracht werden.

In einer weiteren Ausführungsform der Erfindung wird eine Rückelektrode verwendet, die gegenüber Alkaliionen eine vollständige Barrierewirkung besitzt und daher als Diffusionssperrschicht dienen kann. Eine zusätzliche Diffusionssperrschicht ist in dieser Ausführung nicht erforderlich. Eine solche Rückelektrode kann beispielsweise vollständig aus Titannitrid ausgebildet sein. Möglich ist es auch, eine solche Rückelektrode mit vollständiger Barrierewirkung aus zwei Schichten auszubilden, was jedoch wieder der bereits beschriebenen Kombination Rückelektrode/elektrisch leitende Diffusionssperrschicht entspricht.

Im folgenden wird die Erfindung anhand von Ausführungsbeispielen und der dazugehörigen sechs Figuren näher erläutert. Die Figuren zeigen im schematischen Querschnitt die verschiedenen erfindungsgemäßen Möglichkeiten, eine hochwertige Chalkopyrit-Absorberschicht über einem beliebigen Substrat zu erzeugen.

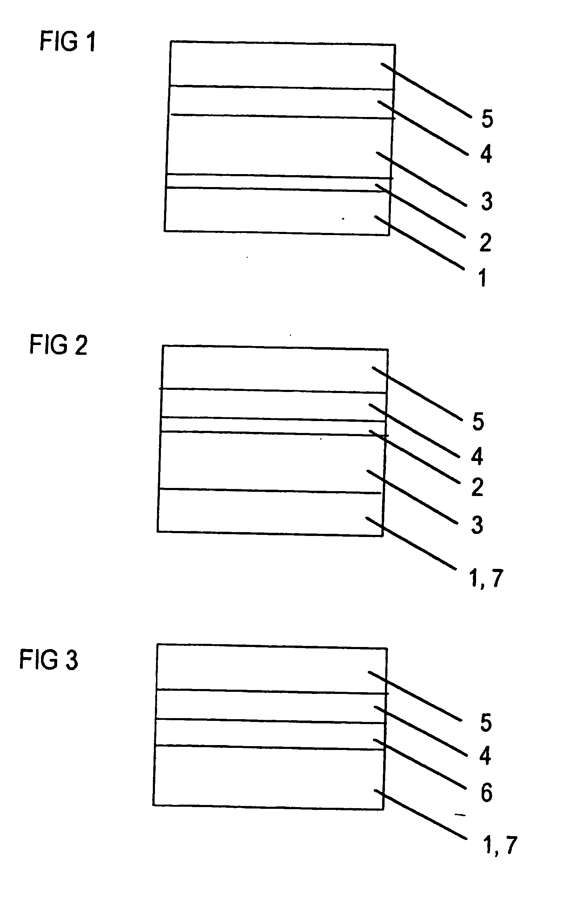

Figur 1: Als alkalihaltiges Substrat 1 dient eine Glasplatte, beispielsweise aus Kalknatronglas. Darüber wird eine Diffusionssperrschicht 2 in einer Schichtdicke von ca. 20 bis 100 nm abgeschieden. Als Material für die Diffusionssperrschicht können Aluminiumoxid, Titannitrid, Siliziumdioxid, Siliziumnitrid. Titanoxid oder Zirkonoxid dienen.

Darüber wird nun eine Rückelektrode 3 aufgebracht, beispielsweise eine ca. 1 µm dicke Molybdänschicht durch Sputtern.

Im nächsten Schritt wird eine Chalkopyrit-Absorberschicht mit einem gewünschten Alkaligehalt über der Rückelektrode 3 erzeugt. Das Einbringen des gewünschten Alkaligehalts selbst ist dabei abhängig vom Herstellungsverfahren für die Chalkopyrit-Absorberschicht.

Im Zweistufenverfahren wird dazu ein aus Ausgangskomponenten des Verbindungshalbleiters bestehender Mehrschichtaufbau in der geeigneter Schichtdicke erzeugt, der die Elemente des Verbindungshalbleiters in annähernd richtiger Stöchiometrie enthält. In einem zweiten Schritt werden die Ausgangskomponenten zum Verbindungshalbleiter umgesetzt. Ausgangskomponenten können dabei Schichten aus Kupfer, Indium, Gallium, Selen und Schwefel oder deren binären Verbindungen miteinander sein. In einer Variation des zweistufigen Verfahrens kann die nichtmetallische Komponente (Schwefel oder Selen) zumindest zum Teil über eine entsprechend selen- oder schwefelhaltige Atmosphäre zugeführt werden.

In einer vom Herstellungsverfahren des Verbindungshalbleiters unabhängigen Variante wird das Alkalielement vorzugsweise in Form eines Sulfids oder Selenids auf der Rückelektrode 3 abgeschieden. Beim Zweistufenprozeß wird darüber wieder der Mehrschichtaufbau aus den Komponenten des Verbindungshalbleiters erzeugt und anschließend in einem Temperschritt bei Temperaturen von typischerweise über 500°C zum Verbindungshalbleiter umgesetzt.

Es wird der in Figur 1 dargestellte Aufbau erhalten, bei dem sich an der Grenzfläche zur Rückelektrode 3 eine alkalireiche Halbleiterschicht 4 unter einer alkaliärmeren Halbleiterschicht 5 ausgebildet hat.

Alternativ kann das Zudosieren der Alkaliverbindung durch Cosputtern zusammen mit anderen Komponenten des Mehrschichtaufbaus erfolgen.

In einem einstufigen Verfahren zum Herstellen der Absorberschicht werden die Komponenten simultan verdampft und bilden auf dem heißen Substrat direkt den Verbindungshalbleiter aus. In diesem Fall können in der Startphase die entsprechenden Alkaliverbindungen simultan mit den übrigen Komponenten aufgedampft werden.

In Figur 2 ist das Ergebnis einer Verfahrensvariante dargestellt, in der die Schichtenfolge bezüglich Rückelektrode 3 und Diffusionssperrschicht 2 gegenüber der Figur 1 vertauscht ist. Für diese Verfahrensvariante gilt einschränkend, daß die Diffusionssperrschicht aus einem elektrisch leitfähigen Material aufgebaut wird. Als Materialien für Rückelektrode 3 und Diffusionssperrschicht 2 kommen beispielsweise Kombinationen von Molybdän mit Titannitrid, Palladium oder Platin und deren Verbindungen insbesondere mit Silizium in Frage. Auch die Kombinationen von Titan oder anderen Elektrodenmetallen mit Titannitrid sind geeignet.

Das Erzeugen der Absorberschicht bzw. das Einbringen eines Alkaligehalts in die Absorberschicht 4, 5 kann wie beim ersten Ausführungsbeispiel erfolgen.

Figur 3 zeigt einen Schichtaufbau, bei dem eine alkalihaltige Absorberschicht 4, 5 über einer Rückelektrode 6 und einem alkalihaltigen Substrat 1 angeordnet ist. Hier besitzt die Rückelektrode 6 eine vollständige Barrierewirkung gegenüber Alkalionendiffusion und kann daher gleichzeitig als Diffusionssperrschicht über alkalihaltigen Substraten dienen. Geeignete Materialien für diese Rückelektrode 6 sind neben insbesondere Titannitrid auch die für die Ausführung nach Figur 2 geeigneten Materialien.

Die Erzeugung der Chalkopyrit-Absorberschicht und das Einbringen eines Alkaligehalts in die Absorberschicht kann in der bereits beschriebenen Weise erfolgen. Die Zudosierung eines Alkalielementes bzw. einer Alkaliverbindung im Bereich der Grenzschicht zur Rückelektrode 6 führt bei der fertigen Absorberschicht 4, 5 zu einem alkalireichen Schichtbereich 4 und einem alkaliarmen Schichtbereich 5.

In den Ausführungen nach den Figuren 2 und 3, bei denen direkt unter der alkalihaltigen Absorberschicht 4 eine Diffusionssperrschicht 2, 6 angeordnet ist, erfüllt letztere weitere Funktionen: sie dient zur Herstellung eines ohmschen Kontakts zum Halbleiter bzw. zur Chalkopyrit-Absorberschicht 4 und stellt außerdem eine Diffusions- und Reaktionsbarriere für solche Elemente und Verbindungen dar, die beim Herstellungsprozeß der Chalkopyrit-Absorberschicht 4, 5 anfallen und mit der Rückelektrode reagieren könnten. Dies ist insbesondere gegenüber solchen Solarzellen vorteilhaft, bei denen direkt über einer Molybdänrückelektrode eine Chalkopyrit-Absorberschicht erzeugt wird. Durch Reaktion mit Selen oder Schwefel, also mit Komponenten des Chalkopyrit-Verbindungshalbleiters können unter den Herstellbedingungen der Chalkopyrit-Absorberschicht Molybdänsulfide und -selenide entstehen, die einen negativen Einfluß auf die Haftung der Absorberschicht über der Rückelektrode, auf den ohmschen Kontakt zwischen Rückelektrode und Halbleiter und auf weitere elektrische Solarzelleneigenschaften besitzen. Gemäß dieser erfindungsgemäßen Ausführungsform kann daher die Herstellung des Halbleiters weitgehend von den chemischen und physikalischen Eigenschaften der Rückelektrode entkoppelt werden. Reaktionen des Halbleiters mit der Rückelektrode, beispielsweise auch eine Legierungsbildung mit den Halbleiterkomponenten Kupfer, Gallium oder Indium bleiben aus. Aus diesem Grund sind die Ausführungen gemäß Figur 2 und Figur 3 auch für elektrisch isolierende alkalifreie Substrate 7 sinnvoll.

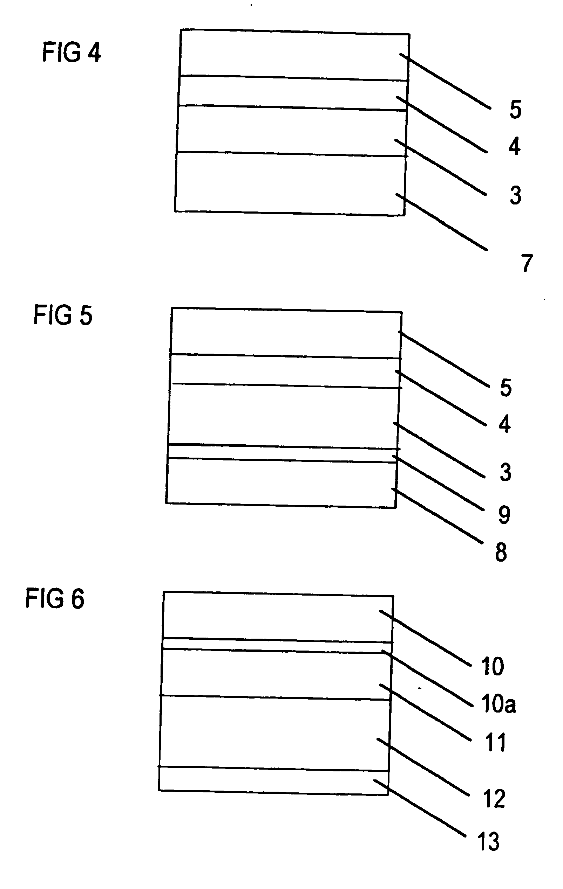

Figur 4 stellt einen weiteren Schichtaufbau mit einem alkalifreien Substrat 7 dar. Dafür sind Keramiken und insbesondere Aluminiumoxid, Zirkonoxid oder Titanoxid geeignet.

Da erfingdungsgemäß hier keine Diffusionssperrschicht für Alkalielemente erforderlich ist, ist auch die Materialauswahl für die Rückelektrode 3 keinen diesbezüglichen Beschränkungen unterworfen.

Die Erzeugung der Absorberschicht erfolgt wie beschrieben, wobei durch Einbringung eines Alkaligehalts im Bereich der Grenzfläche zur Rückelektrode 3 ein alkalireicher Schichtbereich 4 und ein alkaliarmer Schichtbereich 5 ausgebildet wird.

Figur 5 zeigt in einer weiteren Ausgestaltung der Erfindung einen Aufbau über einem ebenfalls alkalifreien jedoch elektrisch leitfähigen Substrat 8. Für diese Ausführung ist allerdings eine zusätzliche Isolatorschicht 9 zwischen Rückelektrode 3 und dem Substrat 8 erforderlich. Sie ist Voraussetzung dafür, daß durch Strukturierung eine integrierte Serienverschaltung des späteren Solarmoduls möglich ist. Neben der elektrischen Isolation dient sie auch als Reaktionsbarriere zwischen Substrat und Rückelektrode und gegebenenfalls als Diffusionsbarriere für Verunreinigungen. Geeignete Materialien für die Isolatorschicht 9 sind Aluminiumoxid, Siliziumoxid oder andere temperaturstabile Isolatoren wie Siliziumnitrid, Zirkonoxid oder Titanoxid. Die Rückelektrode 3 kann auch wahlweise ersetzt werden durch die Rückelektrodenkombinationen 2 und 3 gemäß der Figur 2 oder durch die Rückelektrode 6 der Figur 3, um eine chemische Reaktion der Rückelektrode mit dem Verbindungshalbleiter 4, 5 zu vermeiden.

Die Abscheidung von Rückelektrode 3 und der Absorberschicht 4, 5 unter Hinzudosieren von Natrium, Kalium, Lithium oder einer entsprechenden Alkaliverbindung erfolgt wie beschrieben. In der Absorberschicht bildet sich so wiederum ein alkalreicher Schichtbereich 4 und ein alkaliarmer Schichtbereich 5 aus.

Das weitere Verfahren zur Fertigstellung der Solarzellen erfolgt nach bekannten Methoden. Als n-leitende Fensterschicht wird über der (p-leitenden) Absorberschicht 5 beispielsweise eine 10 bis 50nm dicke Cadmiumsulfidschicht erzeugt. Darüber wird schließlich die Frontelektrode abgeschieden, zum Beispiel in Form einer 1µm dicken Zinkoxidschicht. Generell sind jedoch auch Kombinationen mit anderen Fensterschichten und anderen transparenten Frontelektroden möglich.

Zum Erzielen einer ausreichend hohen Modulspannung kann die Solarzelle schließlich noch integriert verschaltet werden. Dazu kann jede einzelne Schicht des Solarzellenaufbaus direkt nach ihrer Herstellung strukturiert werden. Dabei ist stets darauf zu achten, daß vor der Fertigstellung der Absorberschicht die Diffusionssperrschicht nicht verletzt wird. Bereits kleinste strukturelle Fehler in der Diffusionssperrschicht können nach einer Temperung zu einer Erhöhung der Alkalikonzentration in der Absorberschicht führen. Ohne nachfolgende Temperung hat die Beschädigung oder Entfernung der Diffusionssperrschicht entlang von Strukturierungslinien keine Erhöhung der Alkalikonzentration zur Folge.

Figur 6 zeigt eine weitere Ausgestaltung der Erfindung, der Konzept der Superstratezelle zugrundeliegt. Der Lichteinfall erfolgt bei dieser Zelle durch das transparente Substrat 10, das gegebenenfalls mit einer Diffusiossperrschicht 10a versehen wird, falls Alkaliverunreinigungen im Substrat 10 vorliegen. Das Substrat (bestehend aus den Schichten 10 und 10a) wird anschließend mit einer transparenten Frontelektrode 11 aus TCO (Transparent Conductive Oxide) versehen, die zum Beispiel aus dotierten Metalloxiden wie Zinn- oder Zinkoxid bestehen kann. Der nächste Prozeßschritt besteht in der Erzeugung einer alkalihaltigen Absorberschicht 12. Die Solarzellenherstellung wird abgeschlossen mit einer metallischen Rückelektrode 13, die einen ohm'schen Kontakt zum Verbindungshalbleiter bewirkt.

Ausführungsbeispiel: Sodalime-Substrat/60 nm Al₂O₃/Mo/Na₂Se/CIGS (siehe auch Figur 1)

Auf ein 2 mm dickes Sodalime-Substrat wird direkt nach der Standard-Glasreinigung eine 60 nm dünne geschlossene Al₂O₃-Schicht von einem Al₂O₃-Verbindungstarget mittels Hochfrequenz-Sputtern abgeschieden. Die 60 nm Al₂O₃ dienen hier als Diffusionssperrschicht 2 für Alkali-Verunreinigungen aus dem Kalknatronglas. Anschließend wird eine Rückelektrode 3 aufgebracht, zum Beispiel durch Aufsputtern von 700 nm Molybdän. Die dosierte Einbringung von Alkaliionen geschieht hier durch vollständiges Verdampfen von einer präzise abgewogenen Menge von Na₂Se aus einem Keramik-Schiffchen direkt auf die Mo-Rückelektrode. Die Dosis in diesem Beispiel beträgt 2 x 10¹⁵ Natriumionen pro Quadratzentimeter Rückelektrodenfläche. Die Chalkopyrit-Absorbersichicht wird in dieser Ausführung mit einem schnellen Temperprozeß aus den elementaren Kupfer-, Gallium-, Indium- und Selenschichten hergestellt. Dazu werden die Metalle im Molverhältnis von 0,89 < Cu/(In+Ga) < 0.96 auf das Natriumselenid aufgesputtert, Selen mit einem stöchiometrischen Überschuß von 25 Prozent aufgedampft, und mit dem schnellen Temperprozeß bei typisch 550°C, 10 min in Inertgas und Verkapselung zu CuIn(Ga)Se₂ reagiert. Die Elementeschichtdicken können so variiert werden, daß Absorberschichtdicken von 1 - 3 µm, hier 2 µm, entstehen. Zur Herstellung des Absorbers kann aber auch jede andere Technologie eingesetzt werden wie zum Beispiel Temperung der Cu/Ga/In-Schichten in reaktiver Se-Atmosphäre oder Simultanverdampfung von Cu, Ga, In und Se.

Zur Fertigstellung der Solarzellen wird auf der Absorberschicht 4, 5 nach bekannten Methoden eine 10 - 50 nm dünne Kadmiumsulfid-Fensterschicht erzeugt. Anschließend wird eine transparente Frontelektrode, eine ca. 1 - 1,5 µm dicke ZnO-Schicht mit einem CVD-Verfahren abgeschieden und ein Grid aus 50 nm Cr und 1 µm Al durch eine Maske aufgedampft.

Zum Vergleich wurden Solarzellen auf Sodalime-Substraten mit Al₂O₃-Sperrschicht, allerdings ohne Zugabe von Natriumselenid hergestellt. Ohne Natrium bleiben die Wirkungsgrade der besten Zellen unter 5 Prozent, mit Natriumselenid lagen sie über 10 Prozent. Die gemessenen Zellendaten bei diesem Beispiel betragen im Vergleich:
ohne Na: η < 5 %, V_{OC} < 425 mV, I_{SC} < 21 mA/cm2, FF < 56 % mit Na₂Se: η > 10 %, V_{OC} > 445 mV, I_{SC} > 37 mA/cm2, FF > 65 %

## Patentansprüche

1. Verfahren zum Erzeugen einer Solarzelle auf einem Substrat (1, 7, 8), wobei die Solarzelle Rückelektrode (3, 6), Chalkopyrit-Absorberschicht (4, 5), Fensterschicht und Frontelektrode umfasst, bei dem während der Erzeugung der Absorberschicht (4, 5) eine Verbindung eines Elements dosiert zugegeben wird, welches ausgewählt ist aus Na, K und Li, und bei dem eine zusätzliche Diffusion von Alkaliionen aus dem Substrat in die Absorberschicht während des Herstellverfahrens durch Anordnung einer Diffusionssperrschicht (2, 6, 9, 10a) zwischen Substrat und Absorberschicht oder durch Verwendung eines alkalifreien Substrats (7) verhindert wird, so dass sich in der fertigen Absorberschicht eine gewünschte und durch die Dosierung bestimmte Konzentration des genannten Elements einstellt, bei dem das Element in Form einer Verbindung mit Sauerstoff, Schwefel, Selen oder den Halogeniden auf der Rückelektrode (3) abgeschieden wird.

2. Verfahren nach Anspruch 1, bei dem das dosierte Zugeben der Verbindung des Elements durch Verdampfen erfolgt.

3. Verfahren nach Anspruch 1, bei dem das dosierte Zugeben der Verbindung des Elements durch Sputtern erfolgt.

4. Verfahren nach Anspruch 3, bei dem die Verbindung des Elements zusammen mit einer Komponente der Absorberschicht (4, 5) bei deren Abscheidung durch Sputtern von einem Mischtarget zugegeben wird.

5. Verfahren nach einem der Ansprüche 1 bis 4, bei dem die Solarzelle auf einem Glassubstrat (1) aufgebaut wird, auf dem eine Diffusionssperrschicht (2, 6) angeordnet wird, die ausgewählt ist aus TiN, Al₂O₃, SiO₂, Si₃N₄, ZrO₂ oder TiO₂.

6. Verfahren nach einem der Ansprüche 1 bis 4, bei dem direkt auf einem Glassubstrat (1, 10) eine Elektrodenschicht aufgebracht und darüber eine elektrisch leitende Diffusionssperrschicht (2) angeordnet wird, die ausgewählt ist aus TiN, Pt oder Pd.

7. Verfahren nach einem der Ansprüche 1 bis 6, bei dem eine Chalkopyrit-Absorberschicht (4, 5) aus dem System CuIn(Ga)Se₂(S₂) (=CIGS) erzeugt wird und dafür das (Alkali-)Element oder die Verbindung des Elements in einer auf die Oberfläche der Solarzelle bezogenen Menge von 10¹⁴ bis 10¹⁶ Atomen des Elements pro cm² zugegeben wird.

8. Solarzelle mit einem Substrat (1), einer Rückelektrode (3), Chalkopyrit-Absorberschicht (4, 5), Fensterschicht und Frontelektrode, wobei das Substrat (1) alkalifrei oder alkalihaltig ist und bei alkalihaltigen Substrat (1) zwischen Substrat (1) und Absorberschicht (4, 5) eine Diffusionssperrschicht (2) für Alkaliionen angeordnet ist, wobei die Absorberschicht (4, 5) ein Element aus der Gruppe Na, K und Li in einer Dosis von 10¹⁴ bis 10¹⁶ Atomen pro cm² Absorberschicht (4, 5) enthält, wobei die Absorberschicht (4, 5) einen alkalireichen Schichtbereich (4) im Bereich der Grenzfläche zur Rückelektrode (3) und einen alkaliarmen Schichtbereich (5) aufweist.

9. Solarzelle nach Anspruch 8, die einen Aufbau aus Glassubstrat (1), Molybdän-Rückelektrode (3), Chalkopyrit-Absorberschicht (4, 5) aus dem System CuIn(Ga)Se₂(S₂) (=CIGS) und eine zwischen Absorberschicht und Substrat angeordnete Diffusionssperrschicht (2) besitzt, die ausgewählt ist aus TiN, Al₂O₃, SiO₂, Si₃N₄, ZrO₂ oder TiO₂.

10. Solarzelle nach Anspruch 8 oder 9, deren Diffusionssperrschicht (2) eine Dicke von 20-100 nm aufweist.

11. Solarzelle nach Anspruch 8, bei der direkt auf einem Glassubstrat (1, 10) eine Elektrodenschicht aufgebracht und darüber eine elektrisch leitende Diffusionssperrschicht (2) angeordnet ist, die ausgewählt ist aus TiN, Pt oder Pd.

## Claims

1. A method for producing a solar cell on a substrate (1, 7, 8), wherein the solar cell comprises a back electrode (3, 6), a chalcopyrite absorber layer (4, 5), a window layer, and a front electrode, in which, during the production of the absorber layer (4, 5), a compound of an element is added by doping, which is selected from among Na, K, and Li, and in which an additional diffusion of alkali ions from the substrate into the absorber layer during the production process is prevented by disposing a diffusion barrier layer (2, 6, 9, 10a) between the substrate and the absorber layer or by using alkali-free substrate (7), such that in the finished absorber layer a desired, doping-determined concentration of the element mentioned is established, in which the element is deposited in the form of a compound with oxygen, sulfur, selenium, or the halogenides on the back electrode (3).

2. The method according to claim 1, wherein the doped addition of the compound of the element takes place through evaporation.

3. The method according to claim 1, wherein the doped addition of the compound of the element takes place through sputtering.

4. The method according to claim 3, wherein the compound of the element is added along with a component of the absorber layer (4, 5) during its deposition by sputtering of a mixed target.

5. The method according to one of claims 1 through 4, wherein the solar cell is built on a glass substrate (1), on which is disposed a diffusion barrier layer (2, 6) that is selected from among TiN, Al₂O₃, SiO₂, Si₃N₄, ZrO₂, or TiO₂.

6. The method according to one of claims 1 through 4, wherein an electrode layer is applied directly on a glass substrate (1, 10) and, over that, is disposed an electrically conductive diffusion barrier layer (2) that is selected from among TiN, Pt, or Pd.

7. The method according to one of claims 1 through 6, wherein a chalcopyrite absorber layer (4, 5) is produced from the system CuIn(Ga)Se₂ (S₂)(=CIGS), and for which the (alkali-)element or the compound of the element is added in an amount of 10¹⁴ to 10¹⁶ atoms of the element per cm² based on the surface area of the solar cell.

8. A solar cell with a substrate (1), a back electrode (3), a chalcopyrite absorber layer (4, 5), a window layer, and a front electrode, wherein the substrate (1) is alkali-free or alkali-containing and, in the case of an alkali-containing substrate (1), a diffusion barrier layer (2) for alkali ions is disposed between substrate (1) and absorber layer (4, 5), wherein the absorber layer (4, 5) contains an element from the group Na, K, and Li in a dose of 10¹⁴ to 10¹⁶ atoms per cm² of the absorber layer (4, 5), wherein the absorber layer (4, 5) has an alkali-rich layer region (4) in the region of the boundary to the back electrode (3) and an alkali-poor layer region (5).

9. A solar cell according to claim8, that has a structure comprising a glass substrate (1), a molybdenum back electrode (3), a chalcopyrite absorber layer (4, 5) from the system CuIn(Ga)Se₂ (S₂)(=CIGS), and, disposed between the absorber layer and the substrate, is a diffusion barrier layer (2) that is selected from among TiN, Al₂O₃, SiO₂, Si₃N₄, ZrO₂, or TiO₂.

10. A solar cell according to claim 8 or 9, whose diffusion barrier layer (2) has a thickness of 20 to 100 nm.

11. A solar cell according to claim 8, wherein an electrode layer is applied directly on a glass substrate (1, 10) and, over that, is disposed an electrically conductive diffusion barrier layer (2) that is selected from among TiN, Pt, or Pd.

## Revendications

1. Procédé de fabrication d'une cellule solaire sur un substrat (1, 7, 8), la cellule solaire comprenant une électrode arrière (3, 6), une couche d'absorption de chalcopyrite (4, 5), une couche fenêtre et une électrode avant, dans lequel, pendant la formation de la couche d'absorption (4, 5), un composé d'un élément est ajouté de façon dosée, lequel est choisi parmi Na, K et Li, et dans lequel une diffusion additionnelle d'ions alcalins à partir du substrat dans la couche d'absorption est empêchée pendant le procédé de fabrication par disposition d'une couche barrière à la diffusion (2, 6, 9, 10a) entre le substrat et la couche d'absorption ou par utilisation d'un substrat exempt d'alcalis (7), de manière à ajuster dans la couche d'absorption finie une concentration souhaitée et déterminée par le dosage de l'élément cité, l'élément étant déposé sur l'électrode arrière (3) sous forme d'un composé comprenant de l'oxygène, du soufre, du sélénium ou des halogénures.

2. Procédé selon la revendication 1, dans lequel l'addition dosée du composé de l'élément est réalisée par évaporation.

3. Procédé selon a revendication 1, dans lequel l'addition dosée du composé de l'élément est réalisée par pulvérisation cathodique.

4. Procédé selon la revendication 3, dans lequel le composé de l'élément est ajouté conjointement avec un composant de la couche d'absorption (4, 5) lors de son dépôt par pulvérisation cathodique d'une cible mixte.

5. Procédé selon l'une des revendications 1 à 4, dans lequel la cellule solaire est constituée sur un substrat en verre (1), sur lequel une couche barrière à la diffusion (2, 6) est disposée, laquelle est choisie parmi TiN, Al₂O₃, SiO₂, Si₃N₄, ZrO₂ ou TiO₂.

6. Procédé selon l'une des revendications 1 à 4, dans lequel une couche d'électrode est appliquée directement sur un substrat en verre (1, 10) et sur celle-ci est disposée une couche barrière à la diffusion (2) électriquement conductrice, laquelle est choisie parmi TiN, Pt ou Pd.

7. Procédé selon l'une des revendications 1 à 6, dans lequel une couche d'absorption de chalcopyrite (4, 5) est formée à partir du système CuIn(Ga)Se₂(S₂)(= CIGS) et pour cela l'élément (alcalin) ou le composé de l'élément est ajouté dans une quantité relative à la surface de la cellule solaire, de 10¹⁴ à 10¹⁶ atomes de l'élément par cm².

8. Cellule solaire avec un substrat (1), une électrode arrière (3), une couche d'absorption de chalcopyrite (4, 5), une couche fenêtre et une électrode avant, dans laquelle le substrat (1) est exempt d'alcalis ou contient des alcalis et, pour un substrat (1) contenant des alcalis, une couche barrière à la diffusion (2) pour les ions alcalins est disposée entre le substrat (1) et la couche d'absorption (4, 5), la couche d'absorption (4, 5) contenant un élément parmi le groupe Na, K et Li dans une dose de 10¹⁴ à 10¹⁶ atomes par cm² de la couche d'absorption (4, 5), la couche d'absorption (4, 5) comprenant une région de couche (4) riche en alcalis dans la région d'interface avec l'électrode arrière (3) et une région de couche (5) pauvre en alcalis.

9. Cellule solaire selon la revendication 8, qui comporte une structure avec un substrat en verre (1), une électrode arrière de molybdène (3), une couche d'absorption de chalcopyrite (4, 5) issue du système CuIn(Ga)Se₂(S₂) (= CIGS) et une couche barrière à la diffusion (2) disposée entre la couche d'absorption et le substrat, ladite couche barrière à la diffusion (2) étant choisie parmi TiN, Al₂O₃, SiO₂, Si₃N₄, ZrO₂ ou TiO₂.

10. Cellule solaire selon l'une des revendications 8 ou 9, dans laquelle la couche barrière à la diffusion (2) possède une épaisseur de 20-100 nm.

11. Cellule solaire selon la revendication 8, dans laquelle une couche d'électrode est appliquée directement sur un substrat en verre (1, 10) et une couche barrière à la diffusion (2) électriquement conductrice est disposée sur celle-ci, ladite couche barrière à la diffusion (2) étant choisie parmi TiN, Pt ou Pd.
